# EUROPÄISCHE PATENTSCHRIFT

(11) **EP 2 641 101 B1**
(45) Veröffentlichungstag und Bekanntmachung des Hinweises auf die Patenterteilung: **08.07.2015**
(21) Anmeldenummer: 11788413.0
(22) Anmeldetag: 16.11.2011
(51) Int. Cl.: G01R 33/12

(54) **SPINDETEKTORANORDNUNG ZUM MESSEN DER VEKTORKOMPONENTEN EINES IN EINEM TEILCHENSTRAHL VORHERRSCHENDEN SPINVEKTORS**
SPIN DETECTOR ARRANGEMENT FOR MEASURING THE VECTOR COMPONENTS OF A SPIN VECTOR PREDOMINATING IN A PARTICLE BEAM
ENSEMBLE DE DÉTECTION DE SPIN SERVANT À MESURER LES COMPOSANTES VECTORIELLES D'UN VECTEUR DE SPIN DOMINANT DANS UN FAISCEAU DE PARTICULES

(30) Priorität: 17.11.2010 DE 102010052088
(43) Veröffentlichungstag der Anmeldung: 25.09.2013
(73) Patentinhaber: SPECS Surface Nano Analysis GmbH, 13355 Berlin (DE)
(72) Erfinder: SCHAFF, Oliver, 10439 Berlin (DE)
(74) Vertreter: Theobald, Andreas
(86) Internationale Anmeldenummer: PCT/EP2011/070226
(87) Internationale Veröffentlichungsnummer: WO 2012/066024

(56) Entgegenhaltungen:
- JP-A- 2005 093 106
- JP-A- 2008 251 525
- HUGO DIL J: "TOPICAL REVIEW; Spin and angle resolved photoemission on non-magnetic low-dimensional systems", JOURNAL OF PHYSICS: CONDENSED MATTER, INSTITUTE OF PHYSICS PUBLISHING, BRISTOL, GB, Bd. 21, Nr. 40, 7. Oktober 2009 (2009-10-07), Seite 403001, XP020164488, ISSN: 0953-8984, DOI: 10.1088/0953-8984/21/40/403001

## Beschreibung

Die vorliegende Erfindung betrifft eine Spindetektoranordung zum Detektieren von Vektorkomponenten eines vorherrschenden Spinvektors in einem Teilchenstrahl mit einer vorherrschenden Spinorientierung der Teilchen. Daneben betrifft die Erfindung ein Verfahren zum Detektieren aller Vektorkomponenten eines vorherrschenden Spinvektors in einem Teilchenstrahl mit einer vorherrschenden Spinorientierung der Teilchen.

Spindetektoranordungen zum Detektieren von Vektorkomponenten eines vorherrschenden Spinvektors sind bspw. aus DE 10 2005 045 622 A1, DE 26 46 394 A1, DE 198 42 476 C1, EP 0 490 170 A2, US 4,760,254, US 2010/0155598 A1und JP 61-283890 bekannt.

Die Entgegenhaltungen DE 10 2005 045 622 A1, DE 198 42 476 C1 und DE 26 46 394 A1 beschreiben Verfahren und Anordnungen zum Detektieren von Komponenten des Spinpolarisationsvektors eines Elektronenstrahls, wobei jedoch keine Detektion aller drei Komponenten stattfindet.

Die EP 0 490 170 A2 beschreibt eine Spindetektoranordung, in der ein ferromagnetisches Target Verwendung findet, dessen Polarisationsrichtung eine bestimmte Richtung aufweist. Der Polarisationsvektor eines zu messenden Elektronenstrahls, wird mittels eines Rotators mit einer konstanten Winkelgeschwindigkeit gedreht. Mit Hilfe eines Log-in-Verstärkers, wird ein Wechselstromsignal am Target detektiert, wobei ein dem Rotator zugeführtes sägezahnförmiges Stromsignal als Referenz Verwendung findet. Aus der Phasendifferenz zwischen dem sägezahnförmigen Referenzsignal und dem detektierten Wechselstromsignal wird der Winkel zwischen dem Polarisationsvektor des auf das Target auftreffenden Elektronenstrahls und dem Magnetisierungsvektor des Targets ermittelt. Um mit diesem Verfahren alle drei Komponenten des Polarisationsvektors zu ermitteln, findet ein Detektor mit vier Targets Verwendung.

Die US 4,760,254 beschreibt ein Gerät und ein Verfahren zum Messen des Spinpolarisationsvektors eines Elektronenstrahls, mit dem alle drei Komponenten des Spinpolarisationsvektors gemessen werden können. Hierzu weist das Gerät einen sphärischen Kondensator auf, der in Sichtlinie des einlaufenden Elektronenstrahls eine Öffnung aufweist. Je nachdem, ob der Kondensator geladen ist oder nicht, wird der Elektronenstrahl einem ersten oder einem zweiten Target zugeführt. Während das eine Target zur Messung der x-Komponente und der y-Komponente Verwendung findet, findet das andere Target zum Messen der y-Komponente und der z-Komponente Verwendung.

JP 61-283890 beschreibt eine Vorrichtung, mit der alle drei Komponenten des Spinpolarisationsvektors eines Elektronenstrahls gemessen werden können. Hierzu durchläuft der Elektronenstrahl nacheinander zwei Targets, wobei zwischen dem ersten und dem zweiten Target ein sphärischer Deflektor den Elektronenstrahl ablenkt.

Zum Messen aller drei Komponenten des Spinpolarisationsvektors findet in diesem Stand der Technik also mehrere Targets Verwendung.

Auch die US 2010/0155598 A1 beschreibt einen Elektronenspindetektor, mit dem alle drei Komponenten eines Spinpolarisationsvektors ermittelt werden können. Das Detektieren erfolgt unter Zuhilfenahme eines magnetischen Films, der die Detektion eines Spins in einer bestimmten Richtung ermöglicht. Um alle drei Komponenten des Spinpolarisationsvektors zu ermitteln, sind in der Vorrichtung zwei Spinrotatoren vorhanden, mit denen jede beliebige Komponente des Spinpolarisationsvektors in die detektierbare Richtung gebracht werden kann.

Die JP 2005093106A beschreibt ein scanning electron microscope, bei dem sich eine Probe in einem von einer Spule erzeugten Magnetfeld befindet. Von der Probe ausgehende spinpolarisierte Elektronen werden einem sphärischen Deflektor zugeführt. Aufgrund des Magnetfeldes der Spule rotieren die Elektronenspins um die Bewegungsrichtung, wobei die Elektronenspins bei Eintritt in den Deflektor nicht mehr rotieren und die Spinrichtung um ca. 18 Grad gedreht ist. Mittels eines dem sphärischen Deflektor nachgeschalteten Wienfilters könne die Elektronenspins nach dem Durchtritt durch den sphärischen Deflektor um eine zur Bewegungsrichtung der Elektronen senkrechte Richtung gedreht werden, um mit Hilfe eines Spindetektors auch solche Spinrichtungen detektieren zu können, die vor der Drehung durch den Wienfilter in Bewegungsrichtung der Elektronen lagen.

Es ist eine Aufgabe der vorliegenden Erfindung, eine vorteilhafte Spindetektoranordung zur Verfügung zu stellen, mit der sich alle Vektorkomponenten eines vorherrschenden Spinvektors in einem Teilchenstrahl detektieren lassen. Es ist eine weitere Aufgabe der vorliegenden Erfindung, ein alternatives Verfahren zum Detektieren aller Vektorkomponenten eines in einem Teilchenstrahl vorherrschenden Spinvektors zur Verfügung zu stellen.

Die erste Aufgabe wird durch eine Spindetektoranordung nach Anspruch 1 gelöst, die zweite Aufgabe durch ein Verfahren nach Anspruch 9. Die abhängigen Ansprüche enthalten vorteilhafte Ausgestaltungen der Erfindung.

Eine erfindungsgemäße Spindetektoranordung zum Detektieren von Vektorkomponenten eines vorherrschenden Spinvektors in einem Teilchenstrahl mit einer vorherrschenden Spinorientierung der Teilchen umfasst eine Spinrotator, eine dem Spinrotator nachgeschaltete Ablenkvorrichtung, die die Bahn des Teilchenstrahls bspw. elektrostatisch um einen Ablenkwinkel ablenkt, und einen der elektrostatischen Ablenkvorrichtung nachgeschalteten Spin-Detektor, der die Detektion der Vektorkomponenten eines Spinvektors senkrecht zur Bewegungsrichtung des Teilchenstrahls ermöglicht. Der Spinrotator umfasst zumindest einen schaltbare Spule, die eine Axialrichtung aufweist und derart ausgerichtet ist, dass der Teilchenstrahl entlang der Axialrichtung durch die schaltbare Spule hindurchtritt. Mit der schaltbaren Spule ist eine Schalteinheit verbunden, die ein Schalten des Erregerzustandes der Spule - und damit des von der Spule generierten Magnetfeldes - ermöglicht. Der Spinrotator kann zudem optional eine elektrostatische oder magnetische Linse umfassen.

Mit dem Detektor, der bspw. ein Mottdetektror und insbesondere ein Mikro-Mottdetektor sein kann, können mit Hilfe einer Streuung der Teilchen an einem Target die zur Bewegungsrichtung des Teilchenstrahls beim Auftreffen auf das Target senkrechten Vektorkomponenten des im Teilchenstrahl vorherrschenden Spinvektors detektiert werden. Mit der schaltbaren Spule lässt sich die räumliche Orientierung des im Teilchenstrahl vorherrschenden Spinvektors um die "alte" Bewegungsrichtung des Teilchenstrahls drehen, bevor er durch die Ablenkvorrichtung hindurchtritt. Eine derartige Drehung um die "alte" Bewegungsrichtung bestimmt, welche Vektorkomponenten des im Teilchenstrahl vorherrschenden Spinvektors nach dem Durchtritt durch die Ablenkvorrichtung in der Ebene senkrecht zur "neuen" Bewegungsrichtung, also der Bewegungsrichtung beim Auftreffen auf das Target des Detektors, liegen. Durch ein Schalten der Spule kann daher eine Änderung derjenigen Vektorkomponenten, die sich in der Ebene senkrecht zur "neuen" Bewegungsrichtung befinden, herbeigeführt werden. Vom Detektor werden daher je nachdem, wie die Spule geschaltet ist, unterschiedliche Vektorkomponenten des im Teilchenstrahl vorherrschenden Spinvektors detektiert. Insgesamt können so alle Vektorkomponenten des vorherrschenden Spinvektors detektiert werden.

Gegenüber den eingangs erwähnten Spindetektoren nach Stand der Technik weist die vorliegende Erfindung den Vorteil auf, dass nur ein Target nötig ist.

Mit der erfindungsgemäßen Spindetektoranordung lässt sich das erfindungsgemäße Verfahren zum Detektieren aller Vektorkomponenten eines in einem Teilchenstrahl vorherrschenden Spinvektors durchführen. In diesem Verfahren werden mit dem Detektor nacheinander jeweils zwei Vektorkomponenten des vorherrschenden Spinvektors gemessen, wobei mittels der Schalteinheit bei der einen Messung die Spule des Spinrotators in einen ersten Erregerzustand und bei der anderen Messung in einen zweiten Erregerzustand gebracht wird. Der erste und der zweite Erregerzustand der Spule können sich in der Stromstärke und/oder dem Vorzeichen eines durch die Spule fließenden Stroms voneinander unterscheiden.

In einer ersten beispielhaften Variante kann die Spule im ersten Erregerzustand von einem Strom mit einer bestimmten Stromstärke durchflossen werden und im zweiten Erregerzustand von einem Strom derselben Stromstärke wie im ersten Erregerzustand, der aber im Vergleich zum ersten Erregerzustand ein umgekehrtes Vorzeichen aufweist. Diese Ausgestaltung bietet den Vorteil dass die teilchenoptischen Eigenschaften des Spinrotators durch das Schalten nicht beeinflusst werden, da die Linsenwirkung der Spule nur von der Stromstärke des durch die Spule fließenden Stroms beeinflusst wird, nicht aber durch dessen Vorzeichen.

In einer zweiten beispielhaften Variante des Verfahrens kann die Spule im ersten Erregerzustand von einem Strom mit einer bestimmten Stromstärke größer Null durchflossen werden und im zweiten Erregerzustand von einem Strom mit der Stromstärke Null. In anderen Worten, in dieser Variante wird die Spule im zweiten Erregerzustand nicht von Strom durchflossen. Die Schalteinheit kann dann einfach gehalten werden, da sie lediglich ein Ein- und Ausschalten des durch die Spule fließenden Stroms zu ermöglichen braucht.

Die Stromstärke des durch die Spule fließenden Stroms bestimmt die magnetischen Flussdichte des in der Spule generierten Magnetfeldes. Diese bestimmt wiederum die Geschwindigkeit, mit der der Spinvektor um die "alte" Bewegungsrichtung gedreht wird. Die Stromtärke des durch die Spule fließenden Stroms bestimmt bei vorgegebener Spulenlänge daher den Winkel, um den der vorherrschende Spinvektor um die "alte" Bewegungsrichtung gedreht wird. Durch Einstellen der Stromstärke und des Vorzeichens des durch die schaltbare Spule des Spinrotators fließenden Stromes lassen sich über den Erregerzustand der Spule die Stärke und die Orientierung des Manetfeldes und damit der Winkel, um den der Spinvektor um die "alte" Bewegungsrichtung gedreht wird, und die Drehrichtung einstellen.

Wenn die zuschaltbare Spule des Spinrotators von einem Joch umgeben ist, lassen sich bei gleicher Stromstärke stärkere Magnetfelder generieren. Eine bestimmte Drehung des vorherrschenden Spinvektors kann dann mit einer im Vergleich zu einer Spule ohne Joch kürzeren Spule herbeigeführt werden. Alternativ besteht die Möglichkeit, eine bestimmte Drehung des vorherrschenden Spinvektors bei gleicher Spulenlänge wie mit einer Spule ohne Joch mit einer geringeren Stromstärke herbeizuführen. Außerdem werden durch das Joch Streufelder reduziert, so dass eine Beeinflussung der Abbildungseigenschaften des Spinrotators durch das zugeschaltete Magnetfeld minimiert werden kann.

Weitere Merkmale, Eigenschaften und Vorteile der vorliegenden Erfindung ergeben sich aus der nachfolgenden Beschreibung von Ausführungsbeispielen unter Bezugnahme auf die beiliegenden Figuren,
- Figur 1: zeigt ein Ausführungsbeispiel für eine erfindungsgemäße Spindetektoranordnung in einer schematischen Darstellung.
- Figur 2: zeigt die Drehung des Spins im Magnetfeld.
- Figur 3: zeigt ein konkretes Ausführungsbeispiel für eine erfindungsgemäße Spindetektoranordnung in einer geschnittenen perspektivischen Darstellung.

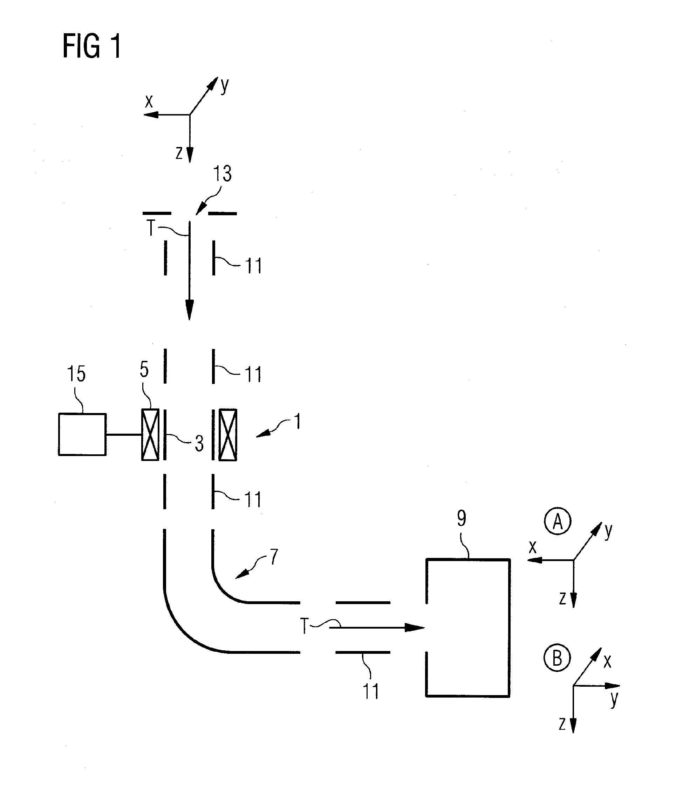

Ein Ausführungsbeispiel für eine erfindungsgemäße Spindetektoranordnung wird nachfolgend mit Bezug auf Figur 1 beschrieben. Als wesentliche Elemente umfasst diese Anordnung einen Spinrotator 1, der im dargestellten Ausführungsbeispiel eine elektrostatische Linse 3 mit einer schaltbaren Spule 5 umfasst, eine dem Spinrotator nachgeschaltete, im vorliegenden Ausführungsbeispiel rein elektrostatisch betriebene Ablenkvorrichtung 7 und einen der elektrostatischen Ablenkvorrichtung nachgeschalteten Spindetektor 9, der im vorliegenden Ausführungsbeispiel als Mikro-Mottdetektor ausgebildet ist. Die erfindungsgemäße Spindetektoranordnung kann darüber hinaus wie im dargestellten Ausführungsbeispiel weitere elektrostatische oder magnetische Elemente 11 umfassen. Diese können beispielsweise weitere elektrostatische Linsen, Driftrohre oder Kondensatoren, mit denen sich die Bahn eines durch die Spindetektoranordnung hindurchtretenden Teilchenstrahls aus ladungsbehafteten Teilchen beeinflussen lässt, sein. Wie beschrieben umfasst der Spinrotator 1 im vorliegenden Ausführungsbeispiel eine elektrostatische Linse. Das Vorhandensein der elektrostatischen Linse ist jedoch keine Voraussetzung für das Funktionieren des Spinrotators. Im einfachsten Fall kann der Spinrotator lediglich die Spule 5 umfassen, mit deren Magnetfeld die Spinrotation herbeigeführt wird. Wenn der Spinrotator zusätzlich zur Spule 5 weitere Elemente umfasst, können anstelle der elektrostatischen Linse 3 oder zusätzlich zu dieser auch andere elektrostatische und/oder magnetische Elemente wie etwa magnetische Linsen, Driftrohre, etc. vorhanden sein.

Ein Teilchenstrahl T tritt durch eine Eintrittsöffnung 13 in die Spindetektoranordnung ein und durchläuft nacheinander den Spinrotator 1, und das elektrostatische Ablenkelement 7, um schließlich in den Mikro-Mottdetektor 9 zu gelangen. Der Teilchenstrahl T enthält Teilchen mit einem Spin, wobei die Orientierung des Spins der im Teilchenstrahl enthaltenen Teilchen eine Vorzugsrichtung aufweist. Diese Vorzugsrichtung wird durch einen Spinvektor repräsentiert, der wiederum durch drei Spinvektorkomponenten festgelegt ist. Dies bedeutet jedoch nicht, dass alle Teilchen des Teilchenstrahls T einen Spin besitzen, der gemäß der Vorzugsrichtung orientiert ist. Vielmehr liegt eine Verteilung der Spinorientierungen der einzelnen Teilchen vor, wobei diese Verteilung ein Maximum bei einer Spinorientierung aufweist, die der Vorzugsrichtung entspricht. Die Schärfe des Maximums, also seine Höhe im Verhältnis zu seiner Breite hängen vom Grad der Polarisierung im Teilchenstrahl ab, der wiederum von dem Prozess abhängt, der die Polarisierung herbeigeführt hat.

Im Mikro-Mottdetektor 9 können mit Hilfe eines ebenen Targets, an dem eine Streuung stattfindet, die von der Polarisationsrichtung der Teilchen in der Targetebene abhängt, und dessen Targetebene senkrecht zur Bezugsrichtung des Teilchenstrahls verläuft, diejenigen Vektorkomponenten des im Teilchenstrahl T vorherrschenden Spinvektors ermittelt werden, die senkrecht zur Bewegungsrichtung des Teilchenstrahls T verlaufen. Wenn in Figur 1 beispielsweise die Richtung, in der der Teilchenstrahl T in die Spindetektoranordnung durch die Eintrittsöffnung 13 eintritt, in einem an den Spin der Teilchen des Teilchenstrahls gekoppelten Koordinatensystem als Z-Richtung definiert wird, so sind die dazu senkrechten Richtungen die X-Richtung und die Y-Richtung. Im dargestellten Ausführungsbeispiel wird der Teilchenstrahl durch das elektrostatische Ablenkelement 7 in seiner Richtung um 90° abgelenkt, ohne die Orientierung seines Spins zu verändern. Daher verläuft seine Bewegungsrichtung im vorliegenden Ausführungsbeispiel nach dem Durchtritt durch das Ablenkelement 7 entgegen der X-Richtung, wie durch die mit A gekennzeichneten Koordinatenachsen angedeutet ist. Im Mikro-Mottdetektor 9 werden dann die Y-Komponente und die Z-Komponente des die vorherrschende Spinorientierung repräsentierenden Spinvektors detektiert, solange der Spinrotator 1 den Spin der Teilchen im Teilchenstrahl nicht dreht. Solange der Spinrotator 1 den Spin nicht dreht, wird die Vorzugsrichtung des Spins im Teilchenstrahl - und damit die Orientierung des daran gekoppelten Koordinatensystems - nicht beeinflusst.

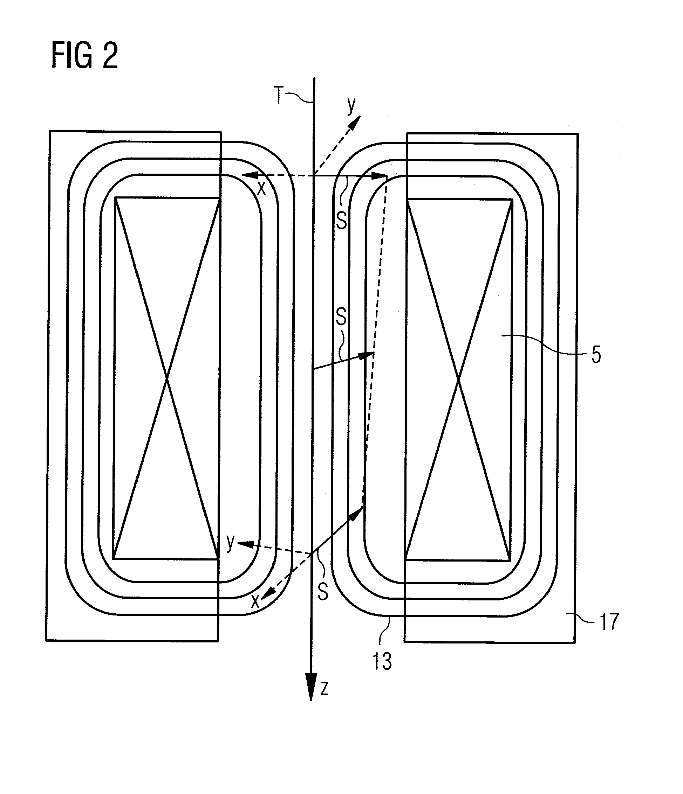

Der Spinrotator 1 weist neben der im vorliegenden Ausführungsbeispiel vorhandenen elektrostatischen Linse 3 auch die schaltbare Spule 5 auf, die derart relativ zur Bewegungsrichtung des Teilchenstrahls T ausgerichtet ist, dass der Teilchenstrahl in Axialrichtung der Spule durch diese hindurchtritt, d.h. die Axialrichtung der Spule verläuft im vorliegenden Ausführungsbeispiel in Z-Richtung des an den Spinvektor des Teilchenstrahls gekoppelten Koordinationssystems. Zum Schalten der Spule 5 weist die Spindetektoranordnung eine Schalteinheit 15 auf, die mit der Spule 5 des Spinrotators 1 verbunden ist. Wenn die Spule 5 im vorliegenden Ausführungsbeispiel zugeschaltet wird, generiert ein Stromfluss durch die Spule 5 ein Magnetfeld im Inneren der Spule. Die Spule 5 mit den Feldlinien einer magnetischen Flussdichte B ist in Figur 2 dargestellt. Außerdem zeigt Figur 2 die Bewegungsrichtung Z des durch die Spule 5 hindurchtretenden Teilchenstrahls T und eine senkrecht zur Bewegungsrichtung Z verlaufende Spinvektorkomponente s. Die Spinvektorkomponente s erfährt im Magnetfeld, dessen Magnetfeldlinien im vorliegenden Ausführungsbeispiel im Inneren der Spule 5 parallel zur Bewegungsrichtung Z des Teilchenstrahls verlaufen, eine Präzession, das heißt eine Drehung um die Bewegungsrichtung Z des Teilchenstrahls T. Der Winkel, um den die Spinkomponente s gedreht wird, hängt dabei von der Stärke des Magnetfeldes sowie dem durch das Magnetfeld zurückgelegten Weg ab. Je stärker das Magnetfeld bei einem vorgegebenen Weg ist, desto schneller dreht sich der Spin und desto größer ist der Drehwinkel nach dem Durchtritt durch das Magnetfeld.

Das Magnetfeld im Inneren der Spule 5 ist im vorliegenden Ausführungsbeispiel als homogenes Magnetfeld dargestellt. Das Vorliegen eines homogenen Magnetfeldes im Inneren der Spule 5 ist aber keine Voraussetzung für das Funktionieren des Spinrotators. Die Rotation des Spins kann nicht nur mit homogenen Magnetfeldern, sondern auch mit inhomogenen Magnetfeldern herbeigeführt werden. Bei Verwendung von inhomogenen Magnetfeldern kann die Spule auch teilchenstrahloptische Funktionen übernehmen, bspw. als magnetische Linse eine Fokussierung oder Defokussierung des Teilchenstrahls herbeiführen.

Im vorliegenden Ausführungsbeispiel sind die durch das Magnetfeld zurückzulegende Strecke des Teilchenstrahls T und die Stärke des Magnetfeldes so aufeinander abgestimmt, dass die Spinvektorkomponente s nach dem Durchtritt durch das Magnetfeld um 90° um die Bewegungsrichtung gedreht ist. In dem mit dem Spinvektor gekoppelten Koordinatensystem bedeutet dies, dass das Koordinatensystem um 90° um die Z-Achse gedreht wird. Wenn also ein Spinvektor im Koordinatensystem A eine bestimmte Orientierung aufweist, weist er nach dem Durchtritt durch den Spinrotator mit eingeschaltetem Magnetfeld diese Orientierung im Koordinatensystem B auf. Mit anderen Worten, der Spinvektor wird noch immer durch denselben Wert der X-Koordinate, der Y-Koordinate und der Z-Koordinate repräsentiert, wobei jedoch das damit gekoppelte Koordinatensystem um 90° um die Z-Achse gedreht ist. Da im vorliegenden Ausführungsbeispiel nach dem Durchtritt durch das Magnetfeld des Spinrotators 1 nur noch elektrostatische Ablenkungen erfolgen, die die Orientierung des Spinvektors nicht beeinflussen, entspricht die Bewegungsrichtung des Teilchenstrahls T nach dem Durchtritt durch das elektrostatische Ablenkelement 7 nunmehr der Y-Richtung des mit dem Spinvektor verknüpften Koordinatensystems. Im Mikro-Mottdetektor 9 werden daher die X-Komponente und die Z-Komponente des Spinvektors gemessen. Die Abwesenheit einer Beeinflussung der der Orientierung des Spinvektors vereinfacht insbesondere die Darstellung der vorliegenden Erfindung, ist aber keine Notwendigkeit für das Funktionieren der Erfindung. Auch bei einer die Orientierung beeinflussenden magnetischen Ablenkung oder sonstigen Beeinflussung des Teilchenstrahls nach dem Durchtritt durch den Spinotator 1 ist die Erfindung ausführbar, solange der Spin bei einer solchen magnetischen Beeinflussung nicht um die ursprüngliche Bewegungsrichtung soweit gedreht wird, dass die durch den Spinrotator 1 vermittelte Drehung wieder vollständig kompensiert wird. Es ist jedoch vorteilhaft, wenn nach dem Durchtritt durch den Spinrotator 1 keine magnetische Beeinflussung des Teilchenstrahls mehr stattfindet, die den Spin um die ursprüngliche Bewegungsrichtung (Z-Richtung in Figur 1) drehen könnte. Eine Drehung des Spins um die "neue" Bewegungsrichtung des Teilchenstrahls nach dem Durchtritt durch die Ablenkvorrichtung 7 (X-Richtung im Falle der ausgeschalteten Spule, wie in Koordinatensystem A dargestellt, und Y- Richtung im Falle der eingeschalteten Spule, wie in Koordinatensystem B dargestellt) ist dagegen in der Regel unkritisch, da sie die in der zur Bewegungsrichtung senkrechten Ebene liegenden Spinvektorkomponenten in dieser Ebene belässt. Insbesondere ist es aber vorteilhaft, wenn auf dem Weg zum Detektor 9 nur noch elektrostatische Beeinflussungen des Teilchenstrahls stattfinden, um unerwünschte Einflüsse von Magnetfeldern auf die Orientierung des Spins zuverlässig ausschließen zu können.

Mit Hilfe der im Ausführungsbeispiel dargestellten Spindetektoranordnung können also alle drei Komponenten des vorherrschenden Spinvektors in einem Teilchenstrahl T ermittelt werden, indem gemäß dem Ausführungsbeispiel zuerst die Y-Komponente und die Z-Komponente des Spinvektors bei ausgeschalteter Spule 5 des Spinrotators 1 detektiert werden. Danach wird mittels der Schalteinheit 15 das Magnetfeld der Spule 5 zugeschaltet, sodass nun die X-Komponente und die Z-Komponente des Spinvektors detektiert werden.

Im vorliegenden Ausführungsbeispiel ist die Spule 5 von einem Joch 17 umgeben. Dieses vermindert Streufelder, welche die teilchenoptischen Eigenschaften des Spinrotators negativ beeinflussen könnten. Außerdem führt sie zu einer erhöhten Magnetfelddichte im Inneren der Spule, sodass ein vorgegebener Wert der magnetischen Flussdichte im Inneren der Spule mit einer geringeren Stromstärke des durch die Spule 5 fließenden Stromes erreicht werden kann.

Der Teilchenstrahl kann insbesondere ein Elektronenstrahl sein. Aber auch eine Vorzugsrichtung der Spinorientierung in Teilchenstrahlen, die aus anderen elektrisch geladenen Teilchen bestehen, insbesondere die Vorzugsrichtung der Spinorientierung in Ionenstrahlen, kann mit der beschriebenen Spindetektoranordnung mit allen drei Komponenten detektiert werden.

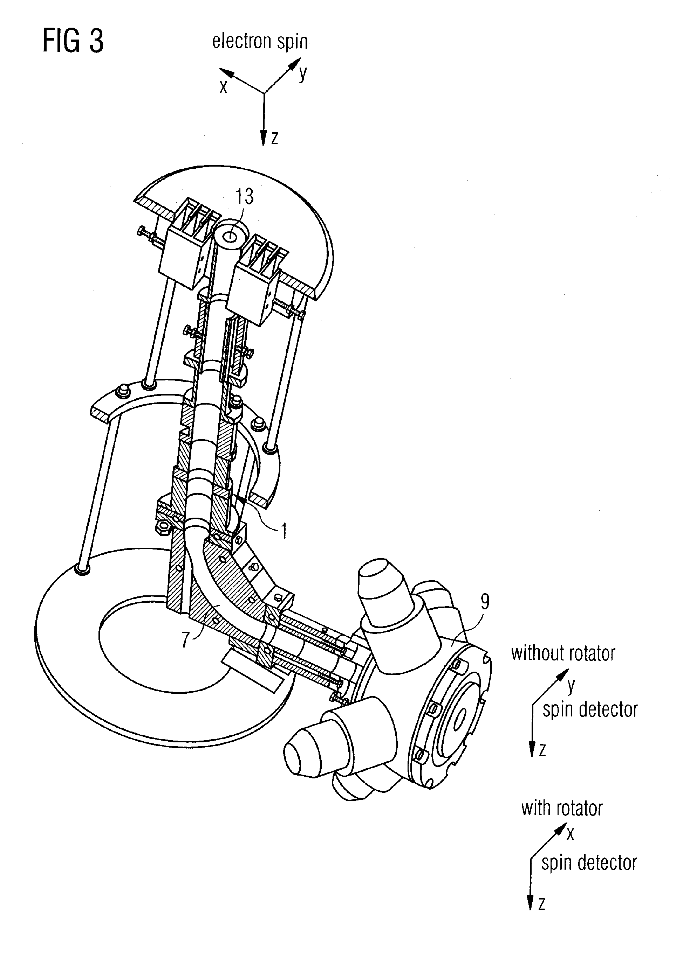

Nachfolgend wird mit Bezug auf Figur 3 ein konkretes Ausführungsbeispiel für die Spindetektoranordnung beschrieben.

Das in der Skizze gezeigte Instrument misst den Spin eines Elektrons, typischerweise am Austritt eines Halbkugel-Photoelektronen-Spektrometers. Das Elektron tritt durch die Eintrittsöffnung (entrance hole 13) in den Detektor ein, mit einer Spinpolarisation ("Spin") mit Komponenten in x,y,z-Richtung. Das elektrostatische Linsensystem inklusive 90° Ablenker 7 leitet das Elektron in den Mikro-Mottdetektor 9. Dort werden zwei von den drei Spinvektorkomponenten gemessen.

Das als "spin rotator lens" dienende Linsenelement 1 ist entweder rein elektrostatisch ("without rotator"), oder es kann ein zusätzliches definiertes Magnetfeld ("with rotator") angelegt werden. Mit diesem zusätzlichen Magnetfeld wird der Elektronenspin um die z-Achse um einen Betrag von 90° gedreht.

Ist das Magnetfeld im spin rotator 1 abgeschaltet ("without rotator"), so kann der Mikro-Mottdetektor die y- und z-Komponente des Spins bestimmen.

Ist das Magnetfeld im spin rotator 1 eingeschaltet ("with rotator"), so kann der Mikro-Mottdetektor die x- und z-Komponente des Spins bestimmen.

Durch An- und Ausschalten des spin rotators kann man also sequentiell alle drei Komponenten des Elektronenspins bestimmen. Ohne den spin rotator 1 kann man nur y- und z-Komponente bestimmen.

Die gesamte Spindetektoranordnung ist in einer Vacuumkammer angeordnet. Der Mikro-Mottdetektor weist ein ebenes Streutarget und vier Channeltrons auf. Der Spinrotator 1 ermöglicht ein schnelles Umschalten zwischen den Spinvektorkomponenten, die mit dem Mikro-Mottdetektor 9 detektiert werden. Die Spindetektoranordnung misst den Teilchenspin, insbesondere einen Elektronenspin, aus genau einem Punkt im E(k)-Raum. Es tritt also keine Energieverschiebung bei der Detektion unterschiedlicher Spinkomponenten auf.

Die vorliegende Erfindung wurde zu Darstellungszwecken anhand von konkreten Ausführungsbeispielen erläutert. Der Fachmann erkennt jedoch, dass Abweichungen von diesen Ausführungsbeispielen möglich sind. Bspw. sind die Schaltzustände der Spule 5 in den Ausführungsbeispielen so gewählt, dass sie in einem Schaltzustand ein Magnetfeld generiert, das eine Rotation des Spins um 90° herbeiführt und in einem anderen Schaltzustand kein Magnetfeld generiert. Alternativ ist es jedoch bspw. auch möglich, die Schaltzustände so zu wählten, dass in dem einen Schaltzustand ein Magnetfeld generiert wird, das eine Rotation des Spins um 45° herbeiführt und in dem anderen Schaltzustand ein Magnetfeld generiert, das eine Rotation des Spins um -45° herbeiführt wird. Diese Ausgestaltung hat den Vorteil, dass die Linsenwirkung, die nur von der Stromstärke des durch die Spule fließenden Stroms beeinflusst wird, nicht aber durch dessen Vorzeichen, in beiden Schaltzuständen gleich ist. Insgesamt kommt es bei den beiden Schaltzuständen aber nur darauf an, dass der Spin um unterschiedliche Winkel gedreht wird (also etwa um 0° im einen Schaltzustand und 90° im anderen Schaltzustand oder 45° im einen Schaltzustand und -45° im anderen Schaltzustand). Hierbei ist es nicht einmal notwendig, dass die Differenz zwischen den beiden Drehwinkeln 90° beträgt. Ein Differenzwinkel von 90° bietet jedoch den Vorteil, dass das Detekteiren der drei Komponenten dann am einfachsten ist. Ebenso braucht das Ablenkelement 7 den Teilchenstrahl nicht unbedingt um 90° abzulenken, eine kleinere Ablenkung ist ebenfalls ausreichend. Jedoch bietet auch hier ein Winkel von 90° den Vorteil, dass das Detekteiren der drei Komponenten dann am einfachsten ist.

### Bezugszeichen

- 1: Spinrotator
- 3: elektrostatische Linse
- 5: zuschaltbare Spule
- 7: elektrostatisches Ablenkelement
- 9: Detektor
- 11: elektrostatische Elemente
- 13: Eintrittsöffnung
- 15: Schalteinheit
- 17: Joch
- B: Feldlinien der magnetischen Flussdichte

## Patentansprüche

1. Spindetektoranordung zum Detektieren von Vektorkomponenten eines vorherrschenden Spinvektors in einem Teilchenstrahl (T) mit einer vorherrschenden Spinorientierung der Teilchen, wobei die Spindetektoranordung umfasst:
- einen Spinrotator (1) mit einer schaltbaren Spule (5), wobei die schaltbare Spule (5) eine Axialrichtung aufweist und derart ausgerichtet ist, dass der Teilchenstrahl (T) entlang der Axialrichtung durch die schaltbare Spule (5) hindurchtritt;
- eine dem Spinrotator (1) nachgeschaltete Ablenkvorrichtung (7), die die Bahn des Teilchenstrahls (T) elektrostatisch um einen Ablenkwinkel ablenkt;
- einen der Ablenkvorrichtung (7) nachgeschalteten Spin-Detektor (9), der die Detektion der zur Bewegungsrichtung des Teilchenstrahls (T) senkrechten Vektorkomponenten des im Teilchenstrahl (T) vorherrschenden Spinvektors ermöglicht, und
- eine mit der schaltbaren Spule (5) verbundene Schalteinheit (15), die
das Schalten des Erregerzustands der Spule (5) ermöglicht,
**dadurch gekennzeichnet, dass**
die Spindetektoranordung so eingerichtet ist, dass, wenn nacheinander jeweils zwei Vektorkomponenten des vorherrschenden Spinvektors gemessen werden, die Spule (5) des Spinrotators (1) mittels der Schalteinheit (15) in einen ersten Erregerzustand und einen zweiten Erregerzustand bringbar ist, so dass sich das von der Spule generierte Magnetfeld schalten lässt.

2. Spindetektoranordung nach Anspruch 1, in welcher der Spinrotator (1) eine elektrostatische Linse (3) umfasst, die von der schaltbaren Spule (5) umgeben ist.

3. Spindetektoranordung nach Anspruch 1 oder Anspruch 2, in der die dem Spinrotator (1) nachgeschaltete Ablenkvorrichtung (7) eine die Ablenkung elektrostatisch herbeiführende Ablenkvorrichtung ist.

4. Spindetektoranordung nach einem der Ansprüche 1 bis 3, in der die dem Spinrotator (1) nachgeschaltete Ablenkvorrichtung (7) die Bahn des Teilchenstrahls (T) elektrostatisch um 90° ablenkt.

5. Spindetektoranordung nach einem der Ansprüche 1 bis 4, in der mittels der Schalteinheit (15) die Stromstärke und/oder das Vorzeichen des durch die schaltbare Spule (5) fließenden Stroms einstellbar ist.

6. Spindetektoranordung nach einem der Ansprüche 1 bis 5, in der die zuschaltbare Spule (5) des Spinrotators (1) von einem Joch (17) umgeben ist.

7. Spindetektoranordung nach einem der Ansprüche 1 bis 6, in der der Detektor (9) ein Detektor ist, mit dem gleichzeitig zwei zueinander senkrechte Vektorkomponenten detektiert werden.

8. Spindetektoranordung nach Anspruch 6, in der der Detektor (9) ein Mottdetektor ist.

9. Verfahren zum Detektieren aller Vektorkomponenten eines in einem Teilchenstrahl (T) vorherrschenden Spinvektors unter Verwendung Spindetektoranordung nach einem der Ansprüche 1 bis 8, in dem mit dem Detektor (9) nacheinander jeweils zwei Vektorkomponenten des vorherrschenden Spinvektors gemessen werden, wobei mittels der Schalteinheit (15) bei der einen Messung die Spule (5) des Spinrotators (1) in einen ersten Erregerzustand und bei der anderen Messung in einen zweiten Erregerzustand gebracht wird.

10. Verfahren nach Anspruch 9, in dem sich der erste und der zweite Erregerzustand der Spule in der Stromstärke und/oder dem Vorzeichen eines durch die Spule fließenden Stroms unterscheiden.

11. Verfahren nach Anspruch 10, in dem die Spule (5) im ersten Erregerzustand von einem Strom mit einer bestimmten Stromstärke durchflossen wird und im zweiten Erregerzustand von einem Strom derselben Stromstärke wie im ersten Erregerzustand, aber mit im Vergleich zum ersten Erregerzustand umgekehrten Vorzeichen durchflossen wird.

12. Verfahren nach Anspruch 10, in dem die Spule (5) im ersten Erregerzustand von einem Strom mit einer bestimmten Stromstärke mit einem Betrag größer Null durchflossen wird und im zweiten Erregerzustand nicht von Strom durchflossen wird.

## Claims

1. A spin detector arrangement for the detection of vector components of a predominant spin vector in a particle beam (T) with a predominant spin orientation of the particles, wherein the spin detector arrangement comprises:
- a spin rotator (1) with a switchable coil (5), wherein the switchable coil (5) has an axial direction and is orientated in such a way that the particle beam (T) passes through the switchable coil (5) along the axial direction;
- a deflecting apparatus (7) which is arranged downstream of the spin rotator (1) and which deflects the path of the particle beam (T) electrostatically by an angle of deflection;
- a spin detector (9) which is arranged downstream of the deflecting apparatus (7) and which allows the detection of the vector components - at a right angle to the direction of movement of the particle beam (T) - of the spin vector predominant in the particle beam (T), and
- a switching unit (15) which is connected to the switchable coil (5) and which allows
the switching of the exciter state of the coil (5),
**characterized in that** the spin detector arrangement is set up in such a way that when two components of the predominant spin vector are measured in each measurement of successive measurements the coil (5) of the spin rotator (1) is capable of being brought into a first exciter state and a second exciter state by means of the switching unit (15), so that the magnetic field generated by the coil can be switched.

2. A spin detector arrangement according to Claim 1, in which the spin rotator (1) comprises an electrostatic lens (3) which is surrounded by the switchable coil (5).

3. A spin detector arrangement according to Claim 1 or Claim 2, in which the deflecting apparatus (7) arranged downstream of the spin rotator (1) is a deflecting apparatus producing the deflection electrostatically.

4. A spin detector arrangement according to any one of Claims 1 to 3, in which the deflecting apparatus (7) arranged downstream of the spin rotator (1) deflects the path of the particle beam (T) electrostatically by 90°.

5. A spin detector arrangement according to any one of Claims 1 to 4, in which the current strength and/or the sign of the current passing through the switchable coil (5) is capable of being set by means of the switching unit (15).

6. A spin detector arrangement according to any one of Claims 1 to 5, in which the switchable coil (5) of the spin rotator (1) is surrounded by a yoke (17).

7. A spin detector arrangement according to any one of Claims I to 6, in which the detector (9) is a detector by which two vector components at a right angle to each other are detected simultaneously.

8. A spin detector arrangement according to Claim 6, in which the detector (9) is a Mott detector.

9. A method of detecting all the vector components of a spin vector predominant in a particle beam (T), using [a] spin detector arrangement according to any one of Claims I to 8, in which two components of the predominant spin vector are measured in succession in each case by the detector (9), wherein the coil (5) of the spin rotator (1) is brought into a first exciter state during one measurement and into a second exciter state during the other measurement by means of the switching unit (15).

10. A method according to Claim 9, in which the first and the second exciter state of the coil differ in the current strength and/or the sign of a current passing through the coil.

11. A method according to Claim 10, in which the coil (5) has a current of a specified strength passing through it in the first exciter state and a current of the same strength as in the first exciter state, but with the sign reversed with respect to the first exciter state, passing through it in the second exciter state.

12. A method according to Claim 10, in which the coil (5) has a current of a specified strength with a value greater than zero passing through it in the first exciter state and has no current passing through it in the second exciter state.

## Revendications

1. Agencement d'un détecteur de spin servant à la détection de composantes vectorielles d'un vecteur de spin dominant dans un faisceau de particules (T) ayant une orientation dominante du spin des particules, où l'agencement du détecteur de spin comprend :
- un rotateur de spin (1) comprenant une bobine commutable (5), où la bobine commutable (5) présente une direction axiale et est orientée de manière telle, que le faisceau de particules (T) traverse la bobine commutable (5) le long de la direction axiale ;
- un dispositif déflecteur (7) monté en aval du rotateur de spin (1), dispositif déflecteur qui dévie électrostatiquement, suivant un angle de déviation, la trajectoire du faisceau de particules (T) ;
- un détecteur de spin (9) monté en aval du dispositif déflecteur (7), détecteur de spin qui permet la détection des composantes vectorielles - perpendiculaires au sens de déplacement du faisceau de particules (T) - du vecteur de spin dominant dans le faisceau de particules (T), et
- une unité de commutation (15) connectée à la bobine commutable (5), unité de commutation qui permet le déclenchement de l'état d'excitation de la bobine (5),
**caractérisé en ce que** l'agencement du détecteur de spin est prévu de manière telle, que lorsque deux composantes vectorielles du vecteur de spin dominant sont mesurées à chaque fois l'une après l'autre, la bobine (5) du rotateur de spin (1) puisse être amenée, au moyen de l'unité de commutation (15), dans un premier état d'excitation et dans un second état d'excitation, de sorte que le champ magnétique généré par la bobine peut être actif.

2. Agencement d'un détecteur de spin selon la revendication 1, dans lequel le rotateur de spin (1) comprend une lentille électrostatique (3) qui est entourée par la bobine commutable (5).

3. Agencement d'un détecteur de spin selon la revendication 1 ou la revendication 2, dans lequel le dispositif déflecteur (7) monté en aval du rotateur de spin (1) est un dispositif déflecteur provoquant électrostatiquement la déviation.

4. Agencement d'un détecteur de spin selon l'une quelconque des revendications 1 à 3, dans lequel le dispositif déflecteur (7) monté en aval du rotateur de spin (1) dévie électrostatiquement, de 90°, la trajectoire du faisceau de particules (T).

5. Agencement d'un détecteur de spin selon l'une quelconque des revendications 1 à 4, dans lequel l'intensité du courant et/ou le signe de polarité du courant traversant la bobine commutable (5) peut être réglé(e) au moyen de l'unité de commutation (15).

6. Agencement d'un détecteur de spin selon l'une quelconque des revendications 1 à 5, dans lequel la bobine commutable (5) du rotateur de spin (1) est entourée par une culasse (17).

7. Agencement d'un détecteur de spin selon l'une quelconque des revendications 1 à 6, dans lequel le détecteur (9) est un détecteur avec lequel sont détectées en même temps deux composantes vectorielles perpendiculaires l'une par rapport à l'autre.

8. Agencement d'un détecteur de spin selon la revendication 6, dans lequel le détecteur (9) est un détecteur de Mott.

9. Procédé servant à la détection de toutes les composantes vectorielles d'un vecteur de spin dominant dans un faisceau de particules (T), en utilisant un agencement de détecteur de spin selon l'une quelconque des revendications 1 à 8, procédé dans lequel deux composantes vectorielles du vecteur de spin dominant sont mesurées à chaque fois avec le détecteur (9), l'une après l'autre, où, au moyen de l'unité de commutation (15), la bobine (5) du rotateur de spin (1) est amenée, au cours de l'une des mesures, dans un premier état d'excitation et, au cours de l'autre mesure, dans un second état d'excitation.

10. Procédé selon la revendication 9, dans lequel le premier et le second états d'excitation de la bobine se différencient par l'intensité du courant et/ou par le signe de polarité d'un courant traversant la bobine.

11. Procédé selon la revendication 10, dans lequel la bobine (5), dans le premier état d'excitation, est traversée par un courant ayant une intensité de courant déterminée et, dans le second état d'excitation, est traversée par un courant ayant la même intensité de courant que dans le premier état d'excitation, mais par comparaison avec le premier état d'excitation, en ayant des signes de polarité inversés.

12. Procédé selon la revendication 10, dans lequel la bobine (5), dans le premier état d'excitation, est traversée par un courant ayant une intensité de courant déterminée dont la valeur est supérieure à zéro et, dans le second état d'excitation, n'est pas traversée par un courant.
